(19) Europäisches Patentamt
European Patent Office
Office européen des brevets

(11) **EP 3 840 028 A1**

(12) **EUROPEAN PATENT APPLICATION**

(43) Veröffentlichungstag:
**23.06.2021 Patentblatt 2021/25**

(51) Int Cl.:
**H01L 21/67** *(2006.01)*    **H01L 21/677** *(2006.01)*
**C23C 14/56** *(2006.01)*

(21) Anmeldenummer: **20212840.1**

(22) Anmeldetag: **09.12.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(30) Priorität: **19.12.2019 DE 102019008884**

(71) Anmelder: **Singulus Technologies AG**
**63796 Kahl am Main (DE)**

(72) Erfinder:
- **Hofmann, Frank**
 **63939 Wörth am Main (DE)**

- **Schmitt, Karl**
 **63877 Sailauf (DE)**
- **Kempf, Stefan**
 **63755 Alzenau (DE)**
- **Amrhein, Andreas**
 **63875 Mespelbrunn (DE)**
- **Cord, Bernhard**
 **63755 Alzenau (DE)**
- **Horlitz, Uwe**
 **63599 Biebergemünd (DE)**

(74) Vertreter: **Vossius & Partner**
**Patentanwälte Rechtsanwälte mbB**
**Siebertstrasse 3**
**81675 München (DE)**

(54) **BEHANDLUNGSANLAGE UND ANTRIEBSEINHEIT FÜR EINE BEHANDLUNGSANLAGE**

(57) Eine Behandlungsanlage weist eine Kammer zur Behandlung eines Substrats oder mehrerer Substrate auf. Eine drehbar gelagerte temperierte Welle (30) definiert einen zylinderförmigen, gasdichten Hohlraum. Eine Heizanordnung (40, 50) ist zum elektrischen Heizen wenigstens eines in der Kammer angeordneten Teils der Welle (30) vorgesehen. Die Heizanordnung (40, 50) weist einen Aufnahmedorn (40) zum Aufnehmen wenigstens eines elektrischen Heizelements (50) auf, der drehfest angeordnet ist und sich in den Hohlraum der Welle (30) erstreckt. Eine Außenfläche des Aufnahmedorns (40) ist durch einen Spalt von einer Innenfläche der Welle (30) beabstandet.

FIG. 2

EP 3 840 028 A1

**Beschreibung**

Gebiet der Erfindung

Die Erfindung betrifft Vorrichtungen und Verfahren zum Behandeln von Substraten. Die Erfindung betrifft insbesondere derartige Vorrichtungen und Verfahren, bei denen sich eine geheizte Welle in eine Kammer erstreckt.

Technisches Gebiet

Behandlungsanlagen zur Behandlung von Substraten, die als Durchlaufanlagen oder Batchanlagen ausgestaltet sein können, finden weithin Verwendung. Beispielhafte Anlagen sind Chalkogen-Bedampfungsanlagen oder Anlagen zur thermischen Behandlung von Substraten, beispielsweise zur Durchführung einer Wärmebehandlung von auf den Substraten aufgebrachten Schichten.

Es kann erforderlich oder wünschenswert sein, in einer Prozesskammer vorhandene Bauteile auf eine bestimmte Temperatur oder einen bestimmten Temperaturbereich zu temperieren. Beispielsweise kann es bei Chalkogen-Bedampfungsanlagen ohne eine derartige Temperierung zu unerwünscht hohen Abscheidungen an nicht temperierten Bauteilen der Behandlungsanlage kommen, die sich nahe an den Substraten oder Substratträgern befinden. Derartige Abscheidungen an Bauteilen der Behandlungsanlage können die Wartungsintervalle in unerwünschter Weise verkürzen.

Während die Temperierung von ortsfesten Elementen in der Prozesskammer häufig mit geringem Aufwand erfolgen kann, kann die Temperierung von sich in die Prozesskammer erstreckenden, insbesondere von sich in der Prozesskammer bewegenden Bauteilen wie sich drehenden Wellen, technisch komplexer sein. So können beispielsweise bei Öl-temperierten Wellen Leckagen an mechanischen Drehdurchführungen technisch bedingt nur schwer zu vermeiden sein. Bei derartigen Öl-temperierten Wellen wird typischerweise erhitztes Thermalöl durch eine mechanische Drehdurchführung in eine doppelwandige Welle eingebracht.

Die DE 10 2009 016677 A1 beschreibet eine mit Dampf beheizbare Hohlwelle. Die Dampfführungen machen die Ausgestaltung komplex.

Die EP 0 918 945 B1 offenbart eine beheizbare Walze, deren Walzenkörper Kanäle mit einer verdampfbaren Flüssigkeit aufweist, wobei eine elektrische Strahlungsheizung vorgesehen ist. Die Verwendung der Kanäle im Walzenkörper macht die Ausgestaltung der Walze komplex.

Die DE 693 659 A offenbart eine elektrisch beheizte Kalanderwalze, deren Walzenmantel einen Walzenkern dicht umschließt. Die elektrischen Komponenten sind dabei fest verbaut.

Die DE 3 033 689 A1 offenbart eine elektrisch beheizbare Walze mit einem Innenrohr und einem koaxial mit Abstand zum Innenrohr angeordneten, einen Walzenmantel bildenden Außenrohr, die einen Ringraum begrenzen, in dem über den Umfang verteilt mehrere stumpf aneinanderstoßende Heizmatten eingelegt sind. Zur Energieversorgung der Heizmatten sind Schleifkontakte vorgesehen. Derartige Schleifkontakte sind verschleißanfällig.

Die DE10 2011 082 334 A1 beschreibt eine Substratbehandlungsanlage zur Behandlung scheibenförmiger Substrate in horizontaler Lage mit einer Transporteinrichtung, die mehrere Transportwalzen mit einem Hohlraum aufweist, in dem ein Heizmittel angeordnet ist. Das Heizmittel soll durch eine Hohlwelle einer Drehdurchführung hindurch von außerhalb in den Hohlraum des Walzenkörpers einführbar sein. Allerdings ist diese Konstruktion unter anderem deshalb nachteilig, weil das Vorsehen einer solchen drehbar gelagerten Hohlwelle technisch aufwendig, teuer und fehleranfällig ist.

Es besteht ein Bedarf an verbesserten Vorrichtungen und Verfahren, mit denen eine sich wenigstens teilweise in einer Prozesskammer einer Behandlungsanlage erstreckende Welle temperiert, insbesondere beheizt, werden kann. Es besteht insbesondere ein Bedarf an derartigen Vorrichtungen und Verfahren, die eine Temperierung der Welle mit einer einfachen Anordnung erlauben und das Problem von Flüssigkeitsleckagen, das bei Öl- oder Dampftemperierten Wellen auftreten kann, vermeiden.

Zusammenfassung der Erfindung

Erfindungsgemäß werden eine Behandlungsanlage, eine Antriebseinheit und Verwendungen derartiger Behandlungsanlagen und Antriebseinheiten mit den in den unabhängigen Ansprüchen angegebenen Merkmalen bereitgestellt. Die abhängigen Ansprüche definieren bevorzugte Ausführungsformen.

Erfindungsgemäß wird eine Ausgestaltung vorgeschlagen, bei der eine elektrische Heizeinrichtung, insbesondere eine Heizpatrone, nicht drehend im Inneren einer Welle angeordnet ist. Ein Aufnahmedorn ist vorgesehen, um eine elektrische Heizeinrichtung oder Heizpatrone aufzunehmen. Der Aufnahmedorn ist relativ zu einer Kammer der Behandlungsanlage nicht drehend angeordnet.

Ein Spalt erstreckt sich zwischen einer Außenfläche des Aufnahmedorns und einer Innenfläche der Welle. Eine Wärmeübertragung zwischen dem Aufnahmedorn und der drehbar gelagerten Welle kann insbesondere durch ein zwischen der Welle und dem Aufnahmedorn vorgesehenes Gas erfolgen. Dabei kann die Wärmeübertragung im Wesentlichen durch Wärmeleitung durch dieses Gas im Inneren der Welle erfolgen.

Durch die Verwendung einer elektrisch temperierten Welle können die bei Öl-Temperierung häufig auftretenden Leckagen an Drehdurchführungen verhindert werden. Die Behandlungsanlage und die darin verwendete Antriebseinheit sind robust und mechanisch einfach ausgeführt.

Durch die Verwendung eines Aufnahmedorns, der sich relativ zur Kammer nicht dreht, kann eine Heizpatrone oder eine andere elektrische Heizeinrichtung einfach und zerstörungsfrei reversibel entnehmbar im Aufnahmedorn angeordnet und elektrisch verbunden werden.

Es ist nicht erforderlich, einen Schleifringkontakt vorzusehen, wie er bei einer sich drehenden Heizpatrone notwendig wäre. Ein derartiger Schleifringkontakt wäre aufwendiger zu implementieren und könnte die Wartungsintervalle in unerwünschter Weise verkürzen.

Zudem ist bei einer sich drehenden Welle eine Temperaturmessung /-regelung nur schwer möglich, da die Thermospannungen auch über Schleifringe abgegriffen werden müssten.

Der stehende, d.h. sich im Betrieb nicht drehende, Aufnahmedorn kann zur Aufnahme konventioneller Heizpatronen, insbesondere von Standard-Heizpatronen, konfiguriert sein.

Der Aufnahmedorn kann so ausgestaltet sein, dass er verhältnismäßig biegesteif ist und auch bei Wellen mit einer Länge von mehr als 600 mm einsetzbar ist.

Eine erfindungsgemäße Behandlungsanlage weist eine Kammer zur Behandlung eines Substrats oder mehrerer Substrate auf. Eine drehbar gelagerte temperierte Welle ist vorgesehen. Die Welle definiert einen zylinderförmigen, vorteilhaft gasdichten, Hohlraum. Die Behandlungsanlage weist eine Heizanordnung zum elektrischen Heizen wenigstens eines in der Kammer angeordneten Teils der Welle auf. Die Heizanordnung weist einen Aufnahmedorn zum Aufnehmen einer elektrischen Heizeinrichtung auf, der drehfest angeordnet ist und sich in den Hohlraum der Welle erstreckt. Eine Außenfläche des Aufnahmedorns ist durch einen Spalt von einer Innenfläche der Welle beabstandet.

Wenn die Welle einen gasdichten Hohlraum definiert, ist der von der Welle definierte Hohlraum gegenüber einem im Inneren der Kammer definierten Behandlungsraum gasdicht abgeschlossen. Nicht ausgeschlossen ist jedoch, dass selbst bei "gasdichtem Hohlraum" der Hohlraum im Inneren der Welle Öffnungen aufweist, die einen Gasdurchtritt zwischen dem Hohlraum im Inneren der Welle und einem außerhalb des Behandlungsraums liegenden Volumen erlaubt. Beispielsweise kann selbst bei einem gasdicht ausgeführtem Hohlraum (worunter insbesondere ein gegenüber dem Behandlungsraum abgedichteter Hohlraum zu verstehen ist) ein Eintritt von Umgebungsluft aus Volumina außerhalb des Behandlungsraums in den Hohlraum im Inneren der Welle und/oder ein Austritt von Luft aus dem Hohlraum im Inneren der Welle in Volumina außerhalb des Behandlungsraums möglich sein. Alternativ oder zusätzlich können Durchführungen, beispielsweise zum Einleiten eines wärmeleitenden Fluids in den Hohlraum und/oder zum Ausleiten eines wärmeleitenden Fluids aus dem Hohlraum vorgesehen sein, wobei der Gasaustausch zwischen dem Behandlungsraum der Kammer und dem Hohlraum im Inneren der Welle unterbunden bleibt.

Wenigstens ein Teil der Welle kann sich in einem durch die Kammer definierten Behandlungsraum erstrecken.

Die elektrische Heizeinrichtung kann eine Heizpatrone sein oder kann eine Heizpatrone aufweisen.

Die Welle kann teilbar ausgeführt sein.

Die Welle kann derart teilbar ausgeführt sein, dass sie in wenigstens zwei unterschiedlichen Orientierungen an der Kammer montierbar ist. Dadurch kann die Behandlungsanlage so umkonfigurierbar sein, dass je nach Montage der Welle die Heizpatrone von unterschiedlichen Seitenwänden der Kammer aus in den Aufnahmedorn einsetzbar ist.

Teilungsstellen der Welle können mit einer Dichtung versehen sein, um ein Volumen, das zwischen dem Aufnahmedorn und der Innenfläche der Welle definiert ist, gegenüber einem durch die Kammer definierten Behandlungsraum abzudichten.

Die Behandlungsanlage kann ferner eine Evakuierungseinrichtung zum Evakuieren des Behandlungsraums aufweisen.

Die Behandlungsanlage kann so ausgestaltet sein, dass der Behandlungsraum auf einen statischen Druck kleiner als 1 Pa, insbesondere kleiner als 0,1 Pa, insbesondere kleiner als $10^{-2}$ Pa, insbesondere kleiner als $10^{-3}$ Pa, und insbesondere kleiner als $10^{-4}$ Pa, evakuierbar ist.

Die Behandlungsanlage kann konfiguriert sein, in einem Volumen, das zwischen dem Aufnahmedorn und der Welle definierten ist, einen Überdruck gegenüber einem durch die Kammer definierten Behandlungsraum aufrecht zu erhalten.

Die Behandlungsanlage kann konfiguriert sein, das zwischen dem Aufnahmedorn und der Welle definierte Volumen bei Evakuierung des Behandlungsraums auf Atmosphärendruck zu halten.

Optional kann in dem zwischen dem Aufnahmedorn und der Welle definierten Volumen ein gasförmiges Medium, insbesondere Luft, Helium oder Wasserstoff, vorhanden sein.

Der Spalt zwischen der Außenfläche des Aufnahmedorns und der Innenfläche der Welle kann größer als 0,3 mm, insbesondere größer als 0,5 mm, insbesondere größer als 0,7 mm, insbesondere größer als 1 mm, sein.

Der Spalt zwischen der Außenfläche des Aufnahmedorns und der Innenfläche der Welle kann kleiner als 4 mm, insbesondere kleiner 3 mm, insbesondere kleiner als 2,2 mm, insbesondere kleiner als 1,9 mm, sein.

Der Spalt kann dabei jeweils in einer Mittelebene zwischen den sich senkrecht zur Rotationsachse der Welle erstreckenden Wänden der Kammer gemessen werden. Falls der Abstand zwischen der Außenfläche des Aufnahmedorns und der Innenfläche der Welle (jeweils gemessen entlang einer Radialrichtung ausgehend von der Mittelachse der Welle) entlang des Umfangs des Aufnahmedorns variiert, kann der Spalt definiert sein als über den Umfang gemittelter Abstand.

Der Spalt zwischen der Außenfläche des Aufnahmedorns und der Innenfläche der Welle kann so bemessen sein, dass die Innenfläche der Welle berührungsfrei um die Außenfläche des Aufnahmedorns rotierbar ist.

Die Außenfläche des Aufnahmedorns kann einen Durchmesser von wenigstens 15 mm, insbesondere wenigstens 20 mm, insbesondere wenigstens 22 mm, aufweisen.

Der Durchmesser der Außenfläche des Aufnahmedorns kann dabei in einer Mittelebene zwischen den sich senkrecht zur Rotationsachse der Welle erstreckenden Wänden der Kammer gemessen werden. Falls der Radius der Außenfläche des Aufnahmedorns (jeweils gemessen entlang einer Radialrichtung ausgehend von der Mittelachse des Aufnahmedorns) entlang des Umfangs des Aufnahmedorns variiert, kann der Durchmesser definiert sein als über den Umfang gemittelter Durchmesser.

Die Außenfläche des Aufnahmedorns kann geschwärzt sein. Wärmeübertragung durch Wärmestrahlung kann so verbessert werden.

Die Innenfläche der Welle kann geschwärzt sein. Wärmeübertragung durch Wärmestrahlung kann so verbessert werden.

Eine Wärmeleitfähigkeit zwischen der Außenfläche des Aufnahmedorns und der Innenfläche der Welle pro axialer Längeneinheit der Außenfläche des Aufnahmedorns kann wenigstens 0,4 W/(K·m), wenigstens 0,5 W/(K·m), wenigstens 0,6 W/(K·m), wenigstens 0,8 W/(K·m) oder wenigstens 0,9 W/(K·m) betragen.

Die Wärmeleitfähigkeit zwischen der Außenfläche des Aufnahmedorns und der Innenfläche der Welle pro axialer Längeneinheit der Außenfläche des Aufnahmedorns kann maximal 9 W/(K·m), maximal 8 W/(K·m), maximal 7 W/(K·m), maximal 6 W/(K·m) oder maximal 4 W/(K·m) betragen.

Die Außenfläche des Aufnahmedorns kann entlang wenigstens eines Abschnitts des Aufnahmedorns zylinderförmig sein.

Die Außenfläche des Aufnahmedorns kann entlang einer Achse des Aufnahmedorns angeordnete Abschnitte mit unterschiedlichen Außenquerschnitten aufweisen. Dies erleichtert die Anordnung von Lagern, z.B. in Endbereichen des Aufnahmedorns mit kleinerem Durchmesser.

Die Behandlungsanlage kann ferner wenigstens ein Lager zwischen dem Aufnahmedorn und der Innenfläche der Welle aufweisen.

Die Welle kann über wenigstens ein weiteres Lager mit der Kammer drehbar verbunden sein.

Der Aufnahmedorn kann eine maximale Wandstärke von wenigstens 2 mm, von wenigstens 3 mm oder von wenigstens 4,5 mm aufweisen.

Die maximale Wandstärke des Aufnahmedorns kann in einer Mittelebene zwischen den sich senkrecht zur Rotationsachse der Welle erstreckenden Wänden der Kammer gemessen werden.

Der Aufnahmedorn kann einen weiteren zylinderförmigen Hohlraum in seinem Inneren definieren.

Die Behandlungsanlage kann eine elektrische Heizeinrichtung, insbesondere eine Heizpatrone, aufweisen, die im weiteren zylinderförmigen Hohlraum des Aufnahmedorns angeordnet ist oder angeordnet werden kann.

Die Heizpatrone kann ein einstückiges Element sein, das in den Hohlraum des Aufnahmedorns einschiebbar ist.

Die Heizpatrone und der Aufnahmedorn können so ausgestaltet sein, dass die Heizpatrone reversibel zerstörungsfrei in den Aufnahmedorn einführbar und daraus entnehmbar ist.

Eine Ausgestaltung der Heizpatrone kann an eine Position einer Dichtung oder eines Lagers angepasst sein, die oder das zwischen dem Aufnahmedorn und der Welle und/oder zwischen verschiedenen miteinander lösbar verbindbaren Teilen der Welle vorgesehen sein kann.

Die Heizpatrone kann so ausgestaltet sein, dass aktive Heizelemente nur in einem Bereich der Heizpatrone angeordnet sind, der (in Axialrichtung der Welle gesehen) beabstandet von der Dichtung und/oder dem Lager endet.

Eine Außenfläche der im Aufnahmedorn angeordneten Heizpatrone kann um höchstens 1 mm, um höchstens 0,5 mm oder um höchstens 0,25 mm von einer Innenfläche des Aufnahmedorns beabstandet sein.

Ein weiterer zylinderförmiger Hohlraum im Inneren des Aufnahmedorns kann ein Material aufweisen, das zwischen der Heizpatrone und dem Aufnahmedorn vorgesehen ist. Insbesondere kann sich zwischen der Heizpatrone bzw. dem elektrischen Heizelement und dem Aufnahmedorn ein Vergussmaterial befinden, mittels dessen das elektrische Heizelement dauerhaft in den Aufnahmedorn integriert wird. Geeignete Vergussmaterialien sind bspw. temperaturbeständige Wärmeleitmedien, bevorzugt auf metallischer Basis. Z.B. kann eine Silberpaste der Firma PELCO zum Einsatz kommen.

Demnach kann das elektrische Heizelement auch ein integraler Bestandteil des Aufnahmedorns sein. Bei dieser Ausführungsform kann das elektrische Heizelement bevorzugt nicht reversibel und zerstörungsfrei aus dem Aufnahmedorn entnommen werden. Vielmehr wird bei dieser Ausführungsform der Aufnahmedorn mitsamt Heizelement ausgetauscht, falls ein Austausch des Heizelements erforderlich wird. Demnach kann der Aufnahmedorn bevorzugt reversibel und zerstörungsfrei zum Austausch des elektrischen Heizelements aus dem Hohlraum der Welle entnommen werden. Dies hat den Vorteil, dass das unter Umständen empfindliche Heizelement beim Einführen in den Aufnahmedorn nicht versehentlich beschädigt werden kann. Vielmehr bilden Heizelement und Aufnahmedorn eine kompakte, formstabile Einheit. Ferner kann bei dieser Anordnung eine besonders gute Wärmeleitung vom Heizelement in den Dorn erzielt werden. Hierfür ist es bevorzugt, dass das zwischen der Heizpatrone und dem Aufnahmedorn vorgesehene Material eine Wärmeleitfähigkeit von wenigstens 4 W/(K·m), stärker bevorzugt von wenigstens 6 W/(K· m) und besonders bevorzugt von wenigstens 8 W/(K·m) aufweist.

Der Aufnahmedorn weist ein erstes Ende auf der Seite des Zugangs zum Hohlraum der Welle sowie ein gegenüberliegendes zweites Ende auf. Bevorzugt ist der Aufnahmedorn an seinem zweiten Ende im Hohlraum der Welle gelagert. Um die korrekte Positionierung des zweiten Endes in diesem Lager beim Einführen des Aufnahmedorns zu erleichtern, weist dieser an seinem zweiten Ende bevorzugt eine Verjüngung oder andere Führungseinrichtung auf, um in das Lager eingeführt zu werden.

Sind Heizpatrone und Aufnahmedorn nicht über ein Vergussmaterial miteinander verbunden, so kann das zwischen der Heizpatrone und dem Aufnahmedorn vorgesehene Material eine Wärmeleitfähigkeit von wenigstens 0,05 W/(K·m) oder wenigstens 0,1 W/(K· m) aufweisen.

Der Aufnahmedorn kann eines oder eine Kombination der folgenden Materialien aufweisen: Normalstahl wie z.B. ST 37-2 oder S235JR (gemäß EN 100025-2), Edelstahl, Aluminium, Aluminiumlegierungen sowie andere Metalle oder Metalllegierungen mit ausreichend hoher Wärmeleitfähigkeit.

Bevorzugt wird der Aufnahmedorn brüniert, um die Oberfläche zu schwärzen.

Die Welle kann eine Länge von wenigstens 600 mm aufweisen.

Die Heizanordnung kann konfiguriert sein, die Welle auf eine Temperatur zwischen 140°C und 220°C zu heizen.

Die Heizanordnung kann konfiguriert sein, die Welle auf eine Temperatur zwischen 160°C und 200°C zu heizen.

Die Heizanordnung kann konfiguriert sein, die Welle auf eine Temperatur von ungefähr 180°C zu heizen.

Die Behandlungsanlage kann eine Beschichtungsanlage sein.

Die Behandlungsanlage kann eine Quelle für Reaktionsgas oder Reaktionsdampf aufweisen.

Die Behandlungsanlage kann eine Anlage zum Aufdampfen von Substanzen bei Temperaturen von wenigstens 140°C der Kammerwand und/oder eingebauten Bauteilen, beispielsweise zum Aufdampfen von Chalkogenen, insbesondere von Selen, sein.

Die Behandlungsanlage kann eine Anlage zur thermischen Behandlung sein.

Die Behandlungsanlage kann einer Temperatursteuerung zur Steuerung oder Regelung einer Temperatur der sich im Aufnahmedorn befindlichen elektrischen Heizeinrichtung aufweisen.

Die Temperatursteuerung kann wenigstens ein Thermoelement aufweisen.

Eine erfindungsgemäße Antriebseinheit für eine Behandlungsanlage weist eine drehbare Welle auf. Die Welle definiert einen zylinderförmigen Hohlraum. Die Antriebseinheit weist eine Heizanordnung zum elektrischen Heizen wenigstens eines Teils der Welle auf, wobei die Heizanordnung einen Aufnahmedorn zum Aufnehmen einer elektrischen Heizeinrichtung, insbesondere einer Heizpatrone, aufweist, der drehfest montierbar ist und der sich in den Hohlraum der Welle erstreckt, wobei eine Außenfläche des Aufnahmedorns durch einen Spalt von einer Innenfläche der Welle beabstandet ist.

Die Antriebseinheit kann ein Thermoelement zum Regeln einer Temperatur der Heizanordnung aufweisen.

Die Welle kann teilbar ausgeführt sein, wobei eine oder mehrere Teilungsstellen der Welle jeweils mit einer Dichtung versehen sind, um ein Volumen, das zwischen dem Aufnahmedorn und der Innenfläche der Welle definiert ist, gegenüber einem Behandlungsraum abzudichten.

Die Antriebseinheit kann eine elektrische Heizeinrichtung, insbesondere eine Heizpatrone, aufweisen, die in einem weiteren zylinderförmigen Hohlraum des Aufnahmedorns angeordnet ist oder angeordnet werden kann.

Eine Ausgestaltung der Heizpatrone kann so an eine Position einer Dichtung oder eines Lagers angepasst sein, die oder das zwischen dem Aufnahmedorn und der Welle und/oder zwischen verschiedenen miteinander lösbar verbindbaren Teilen der Welle vorgesehen sein kann.

Die Heizpatrone kann so ausgestaltet sein, dass aktive Heizelemente nur in einem Bereich der Heizpatrone angeordnet sind, der (in Axialrichtung der Welle gesehen) beabstandet von der Dichtung und/oder dem Lager endet.

Die Antriebseinheit kann so ausgestaltet sein, dass sie in zwei unterschiedlichen Orientierungen an der Behandlungsanlage montierbar ist. Auf diese Weise kann die Behandlungsanlage in einfacher Weise so umkonfiguriert werden, dass die Heizpatrone von unterschiedlichen Seiten der Behandlungsanlage aus in den Aufnahmedorn einführbar ist.

Die Antriebseinheit kann zur Verwendung in der erfindungsgemäßen Behandlungsanlage konfiguriert sein. Weitere optionale Merkmale der Antriebseinheit entsprechen den unter Bezugnahme auf die Behandlungsanlage erläuterten Merkmalen.

Erfindungsgemäß wird ein Verfahren angegeben, das aufweist: Drehen eines drehbar gelagerten Elements in einer Kammer einer Behandlungsanlage, wobei die Behandlungsanlage eine erfindungsgemäße Behandlungsanlage ist und/oder eine erfindungsgemäße Antriebseinheit aufweist.

Das Verfahren kann ein Verfahren zum Beschichten von Substraten sein.

Das Verfahren kann ein Verfahren thermischen Behandlung von Substraten sein, beispielsweise zur Wärmebehandlung von auf den Substraten aufgebrachten Schichten.

Die erfindungsgemäße Behandlungsanlage, die erfindungsgemäße Antriebseinheit und die erfindungsgemäßen Verwendungen erlauben eine Temperierung der Welle mit einer einfachen Anordnung bei der Behandlung von Substraten und vermeiden das Problem von Flüssigkeitsleckagen.

Die Erfindung betrifft insbesondere die nachfolgenden Aspekte:

1. Behandlungsanlage, aufweisend:

eine Kammer (11) zur Behandlung eines Substrats (18) oder mehrerer Substrate (18),
eine drehbar gelagerte temperierte Welle (30), wobei die Welle (30) einen zylinderförmigen, gasdichten Hohlraum definiert, und
eine Heizanordnung (40, 50) zum elektrischen Heizen wenigstens eines in der Kammer (11) angeordneten Teils der Welle (30),
wobei die Heizanordnung (40, 50) einen Aufnahmedorn (40) zum Aufnehmen wenigstens eines elektrischen Heizelements (50), insbesondere einer Heizpatrone, aufweist, der drehfest angeordnet ist und sich in den Hohlraum der Welle (30) erstreckt,
wobei eine Außenfläche (41) des Aufnahmedorns (40) durch einen Spalt (39) von einer Innenfläche (31) der Welle (30) beabstandet ist.

2. Behandlungsanlage nach Aspekt 1, wobei die Welle (30) teilbar ausgeführt ist, wobei Teilungsstellen der Welle (30) mit einer Dichtung (37, 38) versehen sind, um ein Volumen, das zwischen dem Aufnahmedorn (40) und der Innenfläche (31) der Welle (30) definiert ist, gegenüber einem durch die Kammer (11) definierten Behandlungsraum (15) abzudichten.

3. Behandlungsanlage nach Aspekt 1 oder Aspekt 2, ferner aufweisend eine Evakuierungseinrichtung zum Evakuieren des Behandlungsraums (15).

4. Behandlungsanlage nach Aspekt 3, wobei der Behandlungsraum (15) auf einen statischen Druck kleiner als 1 Pa, insbesondere kleiner als 0,1 Pa, insbesondere kleiner als $10^{-2}$ Pa, insbesondere kleiner als $10^{-3}$ Pa, und insbesondere kleiner als $10^{-4}$ Pa evakuierbar ist.

5. Behandlungsanlage nach einem der vorhergehenden Aspekte, wobei die Behandlungsanlage (10) konfiguriert ist, in einem Volumen, das zwischen dem Aufnahmedorn (40) und der Welle (30) definierten ist, einen Überdruck gegenüber einem durch die Kammer (11) definierten Behandlungsraum (15) aufrecht zu erhalten, insbesondere den Druck in dem zwischen dem Aufnahmedorn (40) und der Welle (30) definierten Volumen bei Evakuierung des Behandlungsraums (15) bei Atmosphärendruck zu halten, wobei optional in dem zwischen dem Aufnahmedorn (40) und der Welle (30) definierten Volumen ein gasförmiges Medium, insbesondere Luft, Helium oder Wasserstoff, vorhanden ist.

6. Behandlungsanlage nach einem der vorhergehenden Aspekte,
wobei der Spalt (39) zwischen der Außenfläche (41) des Aufnahmedorns (40) und der Innenfläche (31) der Welle (30) größer als 0,3 mm, größer als 0,5 mm, größer als 0,7 mm oder größer als 1 mm ist.

7. Behandlungsanlage nach einem der vorhergehenden Aspekte,
wobei der Spalt (39) zwischen der Außenfläche (41) des Aufnahmedorns (40) und der Innenfläche (31) der Welle (30) kleiner als 3 mm, kleiner als 2,2 mm oder kleiner als 1,9 mm ist.

8. Behandlungsanlage nach Aspekt 7,
wobei der Spalt (39) so bemessen ist, dass die Innenfläche (31) der Welle (30) berührungsfrei um die Außenfläche (41) des Aufnahmedorns (40) rotierbar ist.

9. Behandlungsanlage nach einem der vorhergehenden Aspekte,
wobei die Außenfläche (41) des Aufnahmedorns (40) einen Durchmesser von wenigstens 15 mm, wenigstens 20 mm oder wenigstens 22 mm aufweist.

10. Behandlungsanlage nach einem der vorhergehenden Aspekte,
wobei die Außenfläche (41) des Aufnahmedorns (40) und/oder die Innenfläche (31) der Welle (30) geschwärzt sind.

11. Behandlungsanlage nach einem der vorhergehenden Aspekte,
wobei eine Wärmeleitfähigkeit zwischen der Außenfläche (41) des Aufnahmedorns (40) und der Innenfläche (31) der Welle (30) pro axialer Längeneinheit der Außenfläche (41) des Aufnahmedorns (40) wenigstens 0,4 W/(K·m) oder wenigstens 0.5 W/(K·m), beträgt.

12. Behandlungsanlage nach einem der vorhergehenden Aspekte,
wobei die Außenfläche (41) des Aufnahmedorns (40) entlang wenigstens eines Abschnitts des Aufnahmedorns (40) zylinderförmig ist.

13. Behandlungsanlage nach Aspekt 12, wobei die Außenfläche (41) des Aufnahmedorns (40) entlang einer Achse des Aufnahmedorns (40) angeordnete Abschnitte mit unterschiedlichen Außenquerschnitten aufweisen.

14. Behandlungsanlage nach einem der vorhergehenden Aspekte,
wobei die Welle (30) über wenigstens ein Lager (14) mit der Kammer (11) drehbar verbunden ist.

15. Behandlungsanlage nach einem der vorhergehenden Aspekte, ferner aufweisend wenigstens ein Lager (60) zwischen dem Aufnahmedorn (40) und der Innenfläche (31) der Welle (30).

16. Behandlungsanlage nach einem der vorhergehenden Aspekte, wobei der Aufnahmedorn (40) einen weiteren zylinderförmigen Hohlraum in seinem Inneren definiert.

17. Behandlungsanlage nach Aspekt 16, ferner aufweisend eine Heizpatrone (50), die im weiteren zylinderförmigen Hohlraum des Aufnahmedorns (40) angeordnet ist oder angeordnet werden kann.

18. Behandlungsanlage nach Aspekt 17, wobei eine Ausgestaltung der Heizpatrone (50) auf eine Position einer Dichtung (16, 17, 37, 38) oder eines Lagers (14, 60) angepasst ist, wobei insbesondere die Heizpatrone (50) so ausgestaltet ist, dass ein aktive Heizelemente enthaltender Bereich (51) der Heizpatrone (50) beabstandet von der Dichtung (16, 17, 37, 38) oder dem Lager (14, 60) endet.

19. Behandlungsanlage nach Aspekt 17 oder Aspekt 18, wobei eine Außenfläche (41) der im Aufnahmedorn (40) angeordneten Heizpatrone (50) um höchstens 1 mm, 0,5 mm oder 0,25 mm von einer Innenfläche (31) des Aufnahmedorns (40) beabstandet ist.

20. Behandlungsanlage nach Aspekt 18 oder Aspekt 19, wobei der weitere zylinderförmige Hohlraum ein Material zwischen der Heizpatrone (50) und dem Aufnahmedorn (40) aufweist, wobei das Material eine Wärmeleitfähigkeit von wenigstens 0,05 W/(K·m), insbesondere von wenigstens 0,1 W/(K·m), bevorzugt wenigstens 4 W/(K·m), stärker bevorzugt von wenigstens 6 W/(K·m) aufweist.

21. Behandlungsanlage nach einem der vorhergehenden Aspekte, wobei das elektrische Heizelement (50) ein integraler Bestandteil des Aufnahmedorns (40), vorzugweise mit diesem vergossen, ist.

22. Behandlungsanlage nach einem der vorhergehenden Aspekte, wobei der Aufnahmedorn (40) zum Austausch des elektrischen Heizelements (50) aus dem Hohlraum der Welle (30) entnommen werden kann.

23. Behandlungsanlage nach Aspekt 22, wobei der Aufnahmedorn an seinem distalen Ende im Hohlraum der Welle (30) gelagert ist und an seinem distalen Ende eine Verjüngung aufweist, um in das Lager (60) eingeführt zu werden.

24. Behandlungsanlage nach einem der vorhergehenden Aspekte, wobei die Welle (30) eine Länge von wenigstens 600 mm aufweist.

25. Behandlungsanlage nach einem der vorhergehenden Aspekte, wobei die Heizanordnung (40, 50) konfiguriert ist, die Welle (30) auf eine Temperatur zwischen 140°C und 220°C, insbesondere auf ungefähr 180°C zu heizen.

26. Behandlungsanlage nach einem der vorhergehenden Aspekte, wobei die Behandlungsanlage eine Beschichtungsanlage ist.

27. Behandlungsanlage nach Aspekt 26, ferner aufweisend eine Quelle für Reaktionsgas oder Reaktionsdampf.

28. Behandlungsanlage nach Aspekt 26 oder Aspekt 27, wobei die Behandlungsanlage eine Anlage zum Aufdampfen von Substanzen bei Temperaturen der Kammerwand und eingebauten Bauteilen von wenigstens 140°C , beispielsweise zum Aufdampfen von Chalkogenen, insbesondere Selen ist.

29. Behandlungsanlage nach einem der vorhergehenden Aspekte, wobei die Behandlungsanlage eine Anlage zur thermischen Behandlung ist.

30. Behandlungsanlage nach Aspekt 29, ferner mit einer Temperatursteuerung zur Steuerung oder Regelung einer Temperatur der sich im Aufnahmedorn (40) befindlichen Heizungseinrichtung (50).

31. Antriebseinheit (20a-c) für eine Behandlungsanlage (10), aufweisend:

eine drehbare Welle (30), wobei die Welle (30) einen zylinderförmigen Hohlraum definiert,
eine Heizanordnung (40, 50) zum elektrischen Heizen wenigstens eines Teils der Welle (30), wobei die Heizanordnung (40, 50) einen Aufnahmedorn (40) zum Aufnehmen wenigstens eines elektrischen Heizelements (50), insbesondere einer Heizpatrone, aufweist, der drehfest montierbar ist und der sich in den Hohlraum der Welle (30) erstreckt, wobei eine Außenfläche (41) des Aufnahmedorns (40) durch einen Spalt (39) von einer Innenfläche (31) der Welle (30) beabstandet ist.

32. Antriebseinheit nach Aspekt 31, ferner mit einem Thermoelement zum Regeln einer Temperatur der Heizanordnung (40, 50).

33. Antriebseinheit nach Aspekt 30 oder Aspekt 32, wobei die Welle (30) teilbar ausgeführt ist, wobei Teilungsstellen der Welle (30) mit einer Dichtung (37, 38) versehen sind, um ein Volumen, das zwischen dem Aufnahmedorn (40) und der Innenfläche (31) der Welle (30) definiert ist, gegenüber einem Behandlungsraum (15) abzudichten.

34. Antriebseinheit nach einem der Aspekte 31 bis 33, ferner aufweisend eine Heizpatrone (50), die in einem weiteren zylinderförmigen Hohlraum des Aufnahmedorns (40) angeordnet ist oder angeordnet werden kann.

35. Antriebseinheit nach Aspekt 34, wobei eine Ausgestaltung der Heizpatrone (50) auf eine Position einer Dichtung (16, 17, 37, 38) oder eines Lagers (14, 60) angepasst ist, wobei insbesondere die Heizpatrone (50) so ausgestaltet ist, dass ein aktive Heizelemente enthaltender Bereich (51) der Heizpatrone (50) beabstandet von der Dichtung (16, 17, 37, 38) oder dem Lager (14, 60) endet.

36. Antriebseinheit nach einem der Aspekte 31 bis 35, wobei das elektrische Heizelement (50) ein integraler Bestandteil des Aufnahmedorns (40), vorzugweise mit diesem vergossen, ist.

37. Antriebseinheit nach einem der Aspekte 31 bis 36, wobei der Aufnahmedorn (40) zum Austausch des elektrischen Heizelements (50) aus dem Hohlraum der Welle (30) entnommen werden kann.

38. Antriebseinheit nach Aspekt 37, wobei der Aufnahmedorn an seinem distalen Ende im Hohlraum der Welle (30) gelagert ist und an seinem distalen Ende eine Verjüngung aufweist, um in das Lager (60) eingeführt zu werden.

39. Antriebseinheit nach einem der Aspekte 31 bis 38, die zur Verwendung in der Behandlungsanlage (10) nach einem der Aspekte 1 bis 30 konfiguriert ist.

41. Verwendung der Behandlungsanlage (10) nach einem der Aspekte 1 bis 30 oder der Antriebseinheit (20a-20c) nach einem der Aspekte 31 bis 39 zum Beschichten von Substraten (18).

42. Verwendung der Behandlungsanlage (10) nach einem der Aspekte 1 bis 30 oder der Antriebseinheit (20a-20c) nach einem der Aspekte 31 bis 39 für eine thermische Behandlung von Substraten (18).

Kurzbeschreibung der Figuren

Bevorzugte Ausführungsbeispiele der Erfindung werden nachfolgend unter Bezugnahme auf die Figuren ausführlich beschrieben, in denen identische Bezugzeichen identische oder ähnliche Elemente bezeichnen.

Figur 1 zeigt eine Seitenansicht einer Behandlungsanlage nach einem bevorzugten Ausführungsbeispiel.
Figur 2 zeigt eine Schnittansicht durch die Behandlungsanlage in einer Schnittebene, die eine Rotationsachse einer temperierten Welle enthält.
Figur 3 zeigt eine Schnittansicht durch die Behandlungsanlage in einer Schnittebene, die die Rotationsachse der temperierten Welle enthält.
Figur 4 zeigt eine Schnittansicht in einer Schnittebene senkrecht zur Rotationsachse der temperierten Welle entlang der in Figur 3 eingezeichneten Linie IV-IV.
Figur 5 zeigt eine Schnittansicht in einer Schnittebene senkrecht zur Rotationsachse der temperierten Welle entlang der in Figur 3 eingezeichneten Linie V-V.
Figur 6 zeigt eine teilweise Schnittansicht durch die Behandlungsanlage im in Figur 3 mit A bezeichneten Bereich in einer Schnittebene, die eine Rotationsachse einer temperierten Welle enthält.
Figur 7 zeigt eine teilweise Schnittansicht durch die Behandlungsanlage im in Figur 3 mit B bezeichneten Bereich in einer Schnittebene, die eine Rotationsachse einer temperierten Welle enthält.
Figur 8 zeigt eine teilweise Schnittansicht durch die Behandlungsanlage im in Figur 3 mit C bezeichneten Bereich in einer Schnittebene, die eine Rotationsachse einer temperierten Welle enthält.
Figur 9 zeigt eine teilweise Schnittansicht durch die Behandlungsanlage im in Figur 3 mit D bezeichneten Bereich in einer Schnittebene, die eine Rotationsachse einer temperierten Welle enthält.
Figur 10 zeigt eine Abhängigkeit einer Temperatur der Welle vom Abstand zwischen einer Außenfläche eines Aufnahmedorns und einer Innenfläche der Welle.
Figur 11 zeigt eine Abhängigkeit einer Temperatur der Welle vom Abstand zwischen einer Außenfläche eines Aufnahmedorns und einer Innenfläche der Welle.
Figur 12 zeigt eine Abhängigkeit einer Temperatur der Welle vom Abstand zwischen einer Außenfläche eines Aufnahmedorns und einer Innenfläche der Welle.

Beschreibung von bevorzugten Ausführungsbeispielen

Während bevorzugte oder vorteilhafte Ausführungsbeispiele unter Bezugnahme auf die Figuren beschrieben werden, können bei weiteren Ausführungsbeispielen zusätzliche oder alternative Ausgestaltungen realisiert werden.
Während beispielsweise unter Bezugnahme auf die Figuren Ausführungsbeispiele im Kontext von Durchlaufanlagen erläutert werden, bei denen eine temperierte Welle zum Transport von Substraten oder Substratträgern dient, sind die Ausführungsbeispiele nicht hierauf beschränkt. Während Ausführungsbeispiele im Kontext von Behandlungsanlagen zur Dampfphasenabscheidung oder zur thermischen Behandlung beschrieben werden, können die offenbarten Ausführungsbeispiele auch zu anderen Zwecken eingesetzt werden.

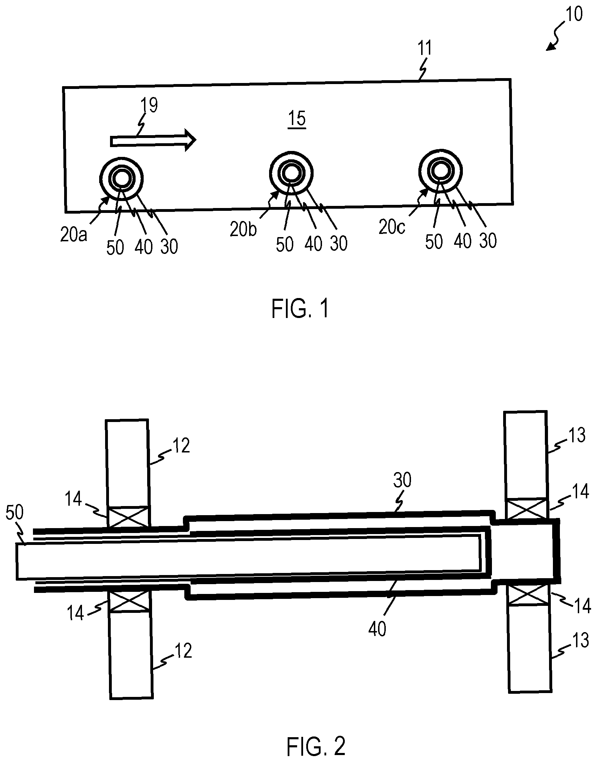

Figur 1 zeigt eine Seitenansicht einer erfindungsgemäßen Behandlungsanlage 10. Die Behandlungsanlage 10 weist eine Kammer 11 auf, die in ihrem Inneren einen Behandlungsraum 15 definiert. Die Behandlungsanlage 10 kann als Durchlaufanlage oder als Batchanlage ausgestaltet sein. Mehrere Antriebseinheiten 20a, 20b, 20c können an der Kammer 11 montiert sein, um Substrate oder einen Substratträger entlang einer Transportrichtung 19 zu bewegen.
Alternativ oder zusätzlich können erfindungsgemäße Antriebseinheiten mit einer temperierten Welle auch zu anderen Zwecken vorgesehen sein, beispielsweise zum Rotieren von Substraten.
Die Antriebseinheiten 20a, 20b, 20c können jeweils eine relativ zur Kammer 11 drehbar gelagerte Welle 30, einen Aufnahmedorn 40 und eine im Aufnahmedorn 40 aufgenommene elektrische Heizeinrichtung 50 aufweisen. Der Aufnahmedorn 40 und die elektrische Heizeinrichtung 50 können eine elektrische Heizanordnung bilden.
Der Aufnahmedorn 40 ist drehfest montiert, so dass er sich selbst bei Drehung der Welle 30 nicht relativ zur Kammer 11 dreht. Der Aufnahmedorn 40 erstreckt sich so in die Welle 30 hinein, dass die Welle 30 berührungsfrei um den Aufnahmedorn 40 drehbar ist.
Figur 2 zeigt eine Schnittansicht durch eine beispielhafte Antriebseinheit 20 in einer Schnittebene, die eine Rotationsachse der Welle 30 enthält. Die Welle 30 kann über Lager 14 an gegenüberliegenden Seitenwänden 12, 13 drehbar gelagert sein. Ein oder mehrere (in Figur 2 nicht dargestellte) Lager können zwischen dem Aufnahmedorn 40 und der Welle 30 vorgesehen sein.
Die Behandlungsanlage 10 kann so ausgestaltet sein, dass der Behandlungsraum 15 auf einen statischen Druck kleiner als 1 Pa, insbesondere kleiner als 0,1 Pa, insbesondere kleiner als $10^{-2}$ Pa, insbesondere kleiner als $10^{-3}$ Pa, und insbesondere kleiner als $10^{-4}$ Pa evakuierbar ist. Hierzu können entsprechende Pumpen und optional steuerbare Ventilanordnungen vorgesehen sein. Die Behandlungsanlage kann (nicht dargestellte) Vakuumschleusen zum Einschleusen von Substraten in den Behandlungsraum 15 und/oder Ausschleusen von Substraten aus dem Behandlungsraum 15 aufweisen.

Die Welle 30 ist derart ausgestaltet, dass ein im Inneren der Welle 30 definierter Hohlraum gegenüber dem Behandlungsraum 15 gasdicht abgedichtet ist. Wenn die Welle 30 mehrteilig ausgeführt ist, kann die Welle Dichtungen zwischen verschiedenen Teilen der Welle 30 aufweisen, um das Innenvolumen der Welle 30 gegenüber dem Behandlungsraum 15 abzudichten.

Im Innenvolumen der Welle 30 kann im Betrieb der Behandlungsanlage 10 ein Überdruck im Vergleich zum Druck im Behandlungsraum 15 herrschen. Dadurch kann insbesondere eine gute thermische Leitfähigkeit durch Wärmeübertragung zwischen dem Aufnahmedorn 40 und der Welle 30 über ein im Innenvolumen der Welle 30 vorhandenes Gas oder Gasgemisch erreicht werden.

Der Aufnahmedorn 40 kann mit einem Außendurchmesser und/oder einer Wandstärke ausgeführt sein, die eine relativ hohe Biegesteifigkeit selbst bei Verwendung in einer langen Welle 30 mit einer Länge von mehr als 600 mm sicherstellt. Die Außenfläche des Aufnahmedorns 40 kann einen Durchmesser von wenigstens 15 mm, insbesondere wenigstens 20 mm, insbesondere wenigstens 22 mm, aufweisen. Der Aufnahmedorn 40 kann eine maximale Wandstärke von wenigstens 2 mm, von wenigstens 3 mm oder von wenigstens 4,5 mm aufweisen.

Eine elektrische Heizeinrichtung 50 kann in den Aufnahmedorn 40 einschiebbar sein. Die elektrische Heizeinrichtung 50 kann einstückig ausgebildet sein, so dass sie einfach in den Aufnahmedorn 40 einschiebbar und daraus entnehmbar ist. Die elektrische Heizeinrichtung 50 kann eine herkömmliche Heizpatrone mit einem Gehäuse und einem oder mehreren im Gehäuse der Heizpatrone angeordneten aktiven Heizelementen sein.

Die elektrische Heizeinrichtung 50 und der Aufnahmedorn 40 sind so ausgestaltet, dass die elektrische Heizeinrichtung 50 im in den Aufnahmedorn 40 eingeführten Zustand durch einen relativ kleinen Spalt von einer Innenfläche des Aufnahmedorns 40 getrennt ist. Eine Außenfläche der im Aufnahmedorn angeordneten Heizpatrone 50 kann beispielsweise um höchstens 1 mm, um höchstens 0,5 mm oder um höchstens 0,25 mm von einer Innenfläche des Aufnahmedorns 40 beabstandet sein. Im Falle der oben diskutierten Variante mit vergossenem Heizelement kann dieser Abstand auch größer sein, da der größere Abstand in diesem Fall mit einem Material höherer Wärmeleitfähigkeit kompensiert werden kann.

Um eine gute Wärmeübertragung von der elektrischen Heizeinrichtung 50 auf den Aufnahmedorn 40 sicherzustellen, kann zwischen dem Aufnahmedorn 40 und der elektrischen Heizeinrichtung 50 im Inneren des Aufnahmedorns 40 ein Medium, insbesondere ein gasförmiges Medium, vorgesehen sein. Das im Inneren des Aufnahmedorns 40 vorgesehene Medium kann eine Wärmeleitfähigkeit $\lambda$ von wenigstens 0,05 W/(K·m) oder wenigstens 0,1 W/(K·m) aufweisen. Wie bereits oben erwähnt, kann im Falle der oben diskutierten Variante mit vergossenem Heizelement das zwischen der Heizpatrone und dem Aufnahmedorn vorgesehene Material eine Wärmeleitfähigkeit von wenigstens 4 W/(K·m), stärker bevorzugt von wenigstens 6 W/(K·m) und besonders bevorzugt von wenigstens 8 W/(K·m) aufweisen.

Da der Aufnahmedorn 40 und die elektrische Heizeinrichtung 50 sich nicht drehen, wird es möglich, diese beiden Komponenten durch nur einen kleinen Spalt zu trennen, so dass eine gute Wärmeübertragung erzielbar ist. Die elektrische Heizeinrichtung 50 kann deshalb einfach gewechselt werden. Dies ist insbesondere der Fall, wenn die elektrische Heizeinrichtung 50 an keinem Funktionselement wie etwa Abstützlager befestigt ist. Die elektrische Heizeinrichtung 50 kann dadurch einen relativ kleinen Durchmesser aufweisen. Eine Durchbiegung der elektrischen Heizeinrichtung 50 ist durch den Aufnahmedorn begrenzt. Die elektrische Heizeinrichtung 50 kann durch einen kleinen Öffnungsdurchmesser auf der Antriebsseite der Drehdurchführung reversibel zerstörungsfrei entnommen werden.

Der Aufnahmedorn 40 besitzt durch seinen größeren Durchmesser eine größere Biegesteifigkeit und gewährleistet dadurch auch bei einer langen Welle 30 eine geringe Durchbiegung. Daher kann ein Spalt zur sich drehenden Welle 30 sowohl über den Umfang des Aufnahmedorns 40 als auch entlang der Längsrichtung der Welle 30 relativ konsistent, d.h. mit nur kleinen Abweichungen über den Umfang und die Längsrichtung der Welle 30, gehalten werden. Dies erlaubt es wiederum, den Spalt zwischen der sich drehenden Welle 30 und dem Aufnahmedorn 40 relativ klein einzustellen.

Beispielsweise kann der Spalt zwischen der Außenfläche des Aufnahmedorns 40 und der Innenfläche der Welle 30 kleiner als 4 mm, kleiner 3 mm, kleiner als 2,2 mm oder kleiner als 1,9 mm sein.

Der Spalt zwischen der Außenfläche des Aufnahmedorns 40 und der Innenfläche der Welle 30 kann größer als 0,3 mm, größer als 0,5 mm, größer als 0,7 mm oder größer als 1 mm sein, um das Risiko einer Berührung zwischen Aufnahmedorn 40 und Welle 30 im Betrieb zu eliminieren oder zu reduzieren.

Der Spalt zwischen der sich drehenden Welle 30 und dem Aufnahmedorn 40 ist größer als der Abstand zwischen der Heizeinrichtung 50 und dem Aufnahmedorn 40.

Durch die Verwendung eines Spalt zwischen der Außenfläche des Aufnahmedorns 40 und der Innenfläche der Welle 30, der beispielsweise größer als 0,3 mm und kleiner als 4 mm ist, kann eine gute thermische Übertragung von Wärmeenergie vom Aufnahmedorn 40 zur Welle 30 erfolgen.

Eine Wärmeleitfähigkeit pro axialer Länge der Welle 30 kann definiert sein als

$$Q/t/|T_1-T_2|, \hspace{4cm} (1)$$

wobei Q eine in einer Zeit t übertragene Wärmeenergie pro Längeneinheit der Welle 30 bezeichnet und $|T_1-T_2|$ einen Absolutbetrag einer Temperaturdifferenz zwischen einer Innenfläche der Welle 30 und eine Außenfläche des Aufnahmedorns 40 bezeichnet.

Die Wärmeleitfähigkeit zwischen der Außenfläche des Aufnahmedorns 40 und der Innenfläche der Welle 30 pro axialer Längeneinheit der Außenfläche des Aufnahmedorns 40 kann wenigstens 0,4 W/(K·m), wenigstens 0,5 W/(K·m), wenigstens 0,6 W/(K·m), wenigstens 0,8 W/(K·m) oder wenigstens 0,9 W/(K·m) betragen.

Die Wärmeleitfähigkeit zwischen der Außenfläche des Aufnahmedorns 40 und der Innenfläche der Welle 30 pro axialer Längeneinheit der Außenfläche des Aufnahmedorns 40 kann maximal 9 W/(K·m), maximal 8 W/(K·m), maximal 7 W/(K·m), maximal 6 W/(K· m) oder maximal 4 W/(K·m) betragen.

Ein relativ großer Außendurchmesser des Aufnahmedorns 40 von wenigstens 15 mm oder wenigstens 20 mm bietet eine größere Mantelfläche zur besseren Energieübertragung zur Welle 40.

Das Material des Aufnahmedorns 40 kann so gewählt sein, dass es eine gute Wärmeleitung aufweist, so dass zwischen Innenfläche und Außenfläche des Aufnahmedorns 40 im Betrieb keine nennenswerte Temperaturdifferenz besteht. Der Aufnahmedorn 40 kann bspw. Normalstahl enthalten oder aus Normalstahl bestehen.

Bevorzugt wird der Normalstahl brüniert, um die Oberfläche zu schwärzen.

Der Aufnahmedorn 40 ist als rein passives Bauteil ausgestaltet. Da der Aufnahmedorn 40 im Betrieb keinen Verschleiß aufweist, ist er keinem Wechselintervall unterworfen. Der Aufnahmedorn 40 kann deshalb so in der Behandlungsanlage montiert sein, dass der Aufnahmedorn 40 nicht von außen wechselbar sein muss. Dies erlaubt es beispielsweise, einen Außendurchmesser des Aufnahmedorns 40 größer als einen Innendurchmesser einer Lagerung für die Welle 30 zu wählen.

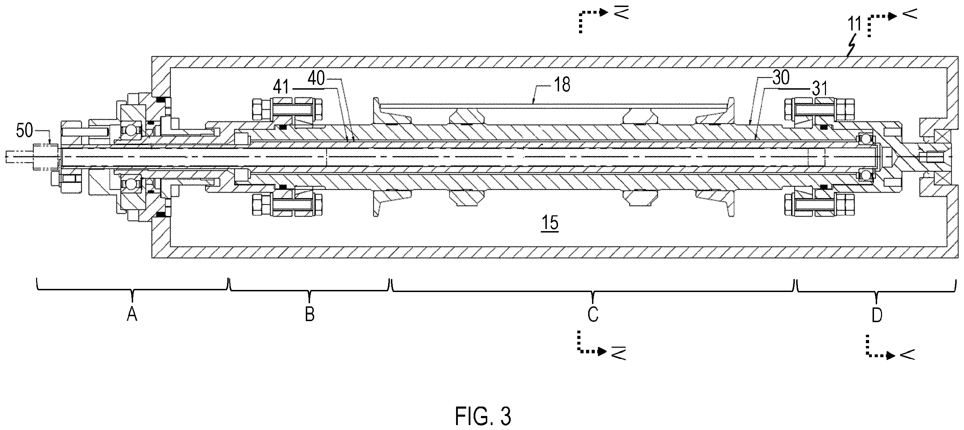

Figur 3 zeigt eine Schnittansicht durch eine Behandlungsanlage mit einer Kammer 11 und einer Antriebseinheit, die eine drehbar gelagerte Welle 30 und eine elektrische Heizanordnung aufweist. Die elektrische Heizanordnung weist den Aufnahmedorn 40 auf, in dem eine elektrische Heizeinrichtung 50 reversibel lösbar montiert sein kann. Der Aufnahmedorn 40 bildet einen Bestandteil der elektrischen Heizanordnung, wobei eine Heizpatrone oder ein anderes elektrisches Heizelement 50 in den Aufnahmedorn 40 einschiebbar ist, so dass es wieder aus dem Aufnahmedorn 40 entnehmbar ist.

Die Welle 30 kann als Transportwalze ausgestaltet sein. Anlageflächen an der Welle 30 können zum seitlichen Führen und/oder Abstützen eines Substrats 18 oder eines Substratträgers 18 dienen. Die Welle 30 ist nicht auf eine derartige Ausgestaltung beschränkt. Beispielsweise kann die Welle 30 auch eine Halterung für ein Substrat drehen, während ein Substrat behandelt wird. Die Welle 30 muss sich nicht in horizontaler Richtung durch die Kammer 11 erstrecken, sondern kann sich beispielsweise auch in vertikaler Richtung in oder durch die Kammer 11 erstrecken.

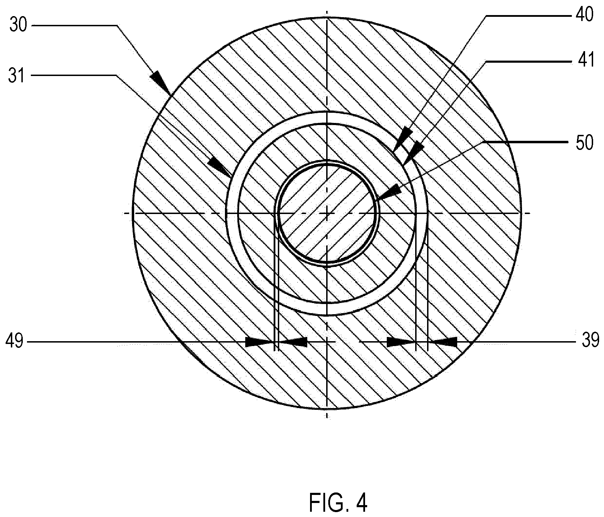

Figur 4 zeigt eine Schnittansicht in einer Schnittebene senkrecht zur Rotationsachse der Welle 30 an der in Figur 3 mit IV-IV bezeichneten Position.

Die relativ zur Kammer 11 drehbar gelagerte Welle 30 weist eine Innenfläche 31 auf. Die Innenfläche 31 kann zur besseren Wärmeübertragung geschwärzt sein.

Der relativ zur Kammer 11 nicht drehbare Aufnahmedorn 40 weist eine Außenfläche 41 auf. Die Außenfläche 41 kann zur besseren Wärmeübertragung geschwärzt sein.

Wie in Figur 4 schematisch dargestellt ist, kann der Aufnahmedorn 40 ein relativ großes Verhältnis seiner Wandstärke zu seinem Außendurchmesser aufweisen. Beispielsweise kann wenigstens in einer senkrecht zur Längsachse des Aufnahmedorns 40 stehenden Mittelebene des Aufnahmedorns eine Quotient aus der Wandstärke des Aufnahmedorns 40 zum Außendurchmesser des Aufnahmedorns 40 wenigstens 0,1, wenigstens 0,15 oder wenigstens 0,2 betragen.

Die Außenfläche 41 des Aufnahmedorns 40 ist durch einen Spalt 39 von der Innenfläche 31 der Welle 30 beabstandet. Eine Innenfläche des Aufnahmedorns 40 kann durch einen weiteren Spalt 49 von einer Außenfläche der elektrischen Heizeinrichtung 50, beispielsweise der Heizpatrone, beabstandet sein, die im Betrieb in den Aufnahmedorn 40 eingeführt ist.

Der Spalt 39 zwischen der Außenfläche 41 des Aufnahmedorns 40 und der Innenfläche 31 der Welle 30 kann von 0,3 mm bis 4 mm, von 0,5 mm bis 3 mm, von 0,7 mm bis 2,2 mm oder von 1 mm bis 1,9 mm betragen.

Der weitere Spalt 49 zwischen der Außenfläche der Heizpatrone 50 und der Innenfläche des Aufnahmedorns 40 kann höchstens 1 mm, höchstens 0,5 mm oder höchstens 0,25 mm betragen.

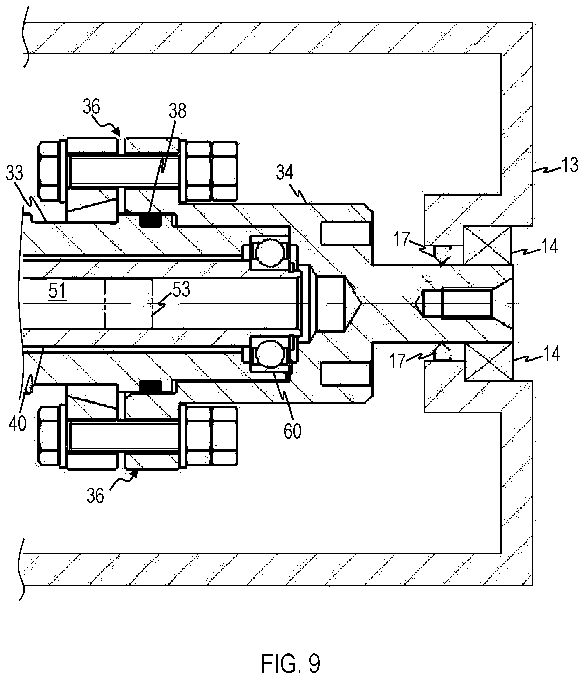

Die Welle 30 und/oder der Aufnahmedorn 40 können entlang einer Längsrichtung der Welle 30 und des Aufnahmedorns 40 einen sich verändernden Querschnitt aufweisen. Beispielsweise können eine Wandstärke und/oder ein Außendurchmesser des Aufnahmedorns 40 entlang der Längsrichtung des Aufnahmedorns 40 variieren. Die Wandstärke und/oder der Außendurchmesser des Aufnahmedorns 40 können in einer Richtung von einer Mitte des Aufnahmedorns 40 hin zu einer der Kammerwände 12, 13 oder hin zu beiden Kammerwänden 12, 13 abnehmen. Dadurch kann beispielsweise der Tatsache Rechnung getragen werden, dass in den Endbereich des Aufnahmedorns 40 typischerweise keine gute Wärmeübertragung zwischen dem Aufnahmedorn 40 und der Welle 30 erforderlich sein muss. Alternativ oder zusätzlich kann Bauraum beispielsweise zur Montage eines (auch in Figur 9 dargestellten) weiteren Lagers 60 zwischen dem Aufnahmedorn 40 und der Welle 30 geschaffen werden.

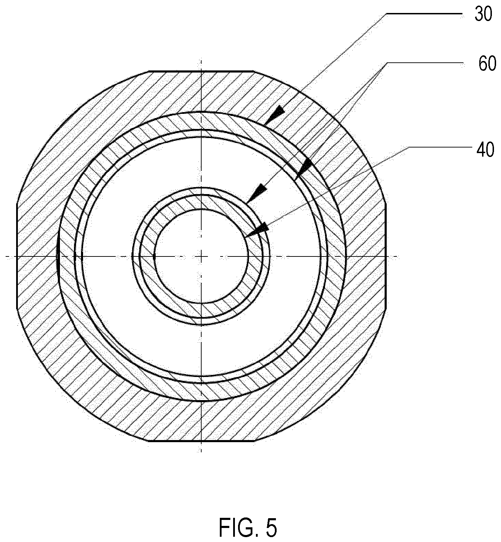

Figur 5 zeigt eine Schnittansicht in einer Schnittebene senkrecht zur Rotationsachse der Welle 30 an der in Figur 3 mit V-V bezeichneten Position, wobei die Schnittebene durch das weitere Lager 60 zwischen dem Aufnahmedorn 40 und der Welle 30 verläuft. Wie sowohl in Figur 5 als auch in Figur 9 sichtbar ist, können die Wandstärke und/oder der Außendurchmesser des Aufnahmedorns 40 von einer zwischen den Seitenwänden 12, 13 liegenden Mittelebene der Behandlungsanlage hin zu einer oder beiden Seitenwänden 12,13 abnehmen.

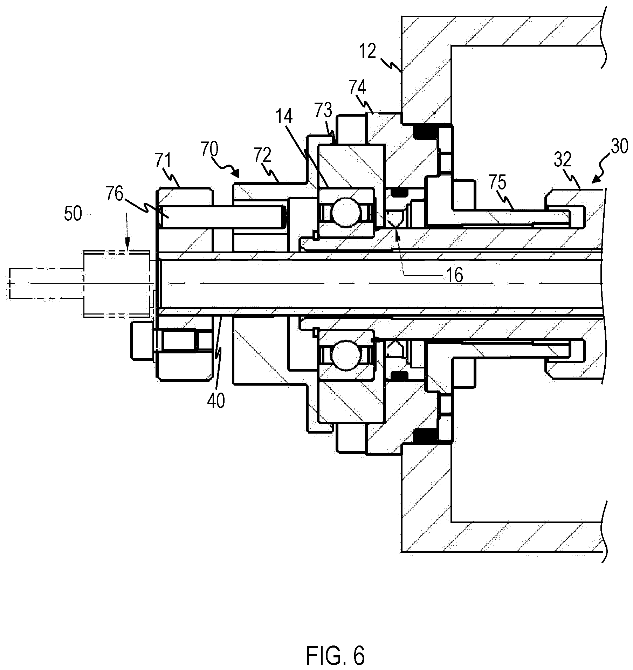

Optionale zusätzliche Ausgestaltungsmerkmale der Behandlungsanlage und Antriebseinheit werden unter Bezugnahme auf die Figuren 6, 7, 8 und 9 beschrieben. Es versteht sich, dass die beschriebenen Merkmale nicht kumulativ vorliegen müssen, sondern die beschriebenen Merkmale in beliebigen Kombinationen eingesetzt werden können.

Dabei zeigen Figuren 6, 7, 8 und 9 Einzelheiten der in Figur 3 mit den Buchstaben A, B, C und D bezeichneten Abschnitte der Behandlungsanlage.

Figur 6 zeigt eine Teilansicht einer Behandlungsanlage nach einem bevorzugten Ausführungsbeispiel. Eine elektrische Heizanordnung weist den Aufnahmedorn 40 auf, der derart an einer Wand 12 der Kammer 11 gelagert ist, dass er sich relativ zu dieser nicht dreht. Die elektrische Heizanordnung kann eine Heizpatrone 50 oder eine andere elektrische Heizeinrichtung aufweisen, die im Betrieb in den Aufnahmedorn 40 eingeführt ist. Die drehbar gelagerte Welle 30 ist über ein Lager 14 drehbar an der Kammer 11 gelagert.

Eine Montageanordnung 70 kann vorgesehen sein, um den Aufnahmedorn 40 nicht drehbar an der Kammer 11 zu befestigen und die Welle 30 drehbar zu lagern. Die Montageanordnung 70 kann mehrteilig mit mehreren Komponenten 71, 72, 73, 74, 75 und 76 ausgeführt sein. Beispielsweise kann eine oder mehrere von der Kammerwand 12 nach außen abstehende Befestigungskomponenten 72 der Montageanordnung 70 ein Ende des Aufnahmedorns 40 so stützen, dass eine Längsachse des Aufnahmedorns 40 mit einer Rotationsachse der Welle 30 zusammenfällt.

Zum Stützen des Aufnahmedorns 40 kann eine (in Figur 6 nicht dargestellte) statische Führung verwendet werden, welche den Aufnahmedorn in Bezug auf die Befestigungskomponente 72 fixiert. Diese Führung kann an der Befestigungskomponente 72 angebracht oder einstückig mit der Befestigungskomponente 72 ausgebildet sein. Dadurch kann sichergestellt werden, dass die Längsachse des Aufnahmedorns 40 mit der Rotationsachse der Welle 30 zusammenfällt.

Die Montageanordnung 70 kann eine oder mehrere Komponenten aufweisen, die den Aufnahmedorn 40 gegen eine Verdrehung sichern. Um den Aufnahmedorn 40 gegen eine Verdrehung zu sichern, können beispielsweise die Befestigungskomponenten 71 und 72 mit Hilfe eines Stifts 76 miteinander verbunden sein. Die Befestigungskomponente 71 kann trennbar mit dem Aufnahmedorn 40 verbunden sein.

Eine Lagerungskomponente 73 der Montageanordnung 70 kann mit einem Außenring des Lagers 14 verbunden sein. Zur sicheren Abdichtung des Behandlungsraums 15 der Kammer 11 können Dichtungskomponenten 74 vorgesehen sein, die eine Dichtung 16 oder mehrere Dichtungen aufweisen und in ihrer Position halten können. Der Hohlzylinder 75 dient der Abschattung des Dampfstrahles, so dass keine Ablagerungen an der Dichtung 16 erfolgen.

Wie in Figur 3, Figur 7 und Figur 9 dargestellt ist, kann die Welle 30 mehrteilig ausgestaltet sein. Die Welle 30 kann mehrere Wellenabschnitte 32,33, 34 aufweisen. Die Wellenabschnitte 32 und 33 können durch Verbinder 35 gasdicht miteinander verbunden sein. Die Wellenabschnitte 33 und 34 können durch weitere Verbinder 36 gasdicht miteinander verbunden sein. An den Verbindungsstellen können Dichtungen 37, 38 vorgesehen sein, die das Innenvolumen der Welle 30 gegenüber dem Behandlungsraum 15 gasdicht abdichten.

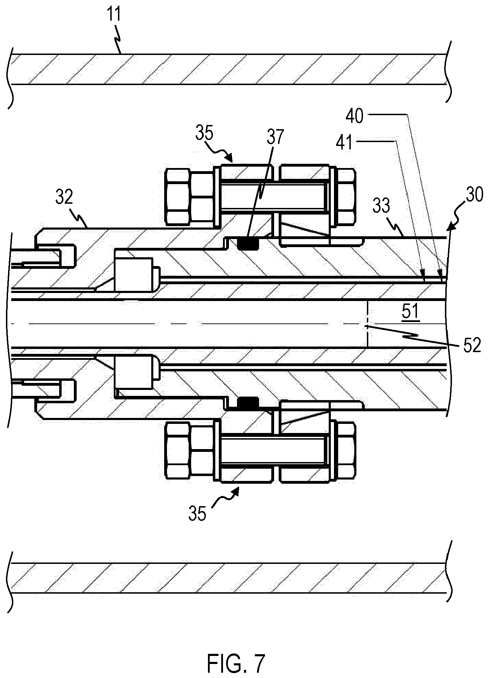

Die Heizpatrone 50 oder eine andere elektrische Heizeinrichtung 50 weist einen Bereich 51 auf, der alle aktiven Heizelemente der elektrischen Heizeinrichtung enthält. Die Heizpatrone 50 oder andere elektrische Heizeinrichtung 50 kann so ausgestaltet sein, dass außerhalb des Bereichs 51 keine aktiven Heizelemente vorhanden sind. Enden 52, 53 des die aktiven Heizelemente enthaltenden Bereichs 51 (die am deutlichsten in Figur 7 und Figur 9 erkennbar sind) sind dabei so positioniert, dass die Enden 52, 53 des Bereichs 51 in Längsrichtung der Welle 30 beabstandet von den Dichtungen und/oder Lagern 14, 60 positioniert sind. Die Dichtungen und oder Lager 14, 60 sind so angeordnet, dass sie in Axialrichtung der Welle 30 gesehen nicht mit dem alle aktiven Heizelemente enthaltenden Bereich 51 überlappen.

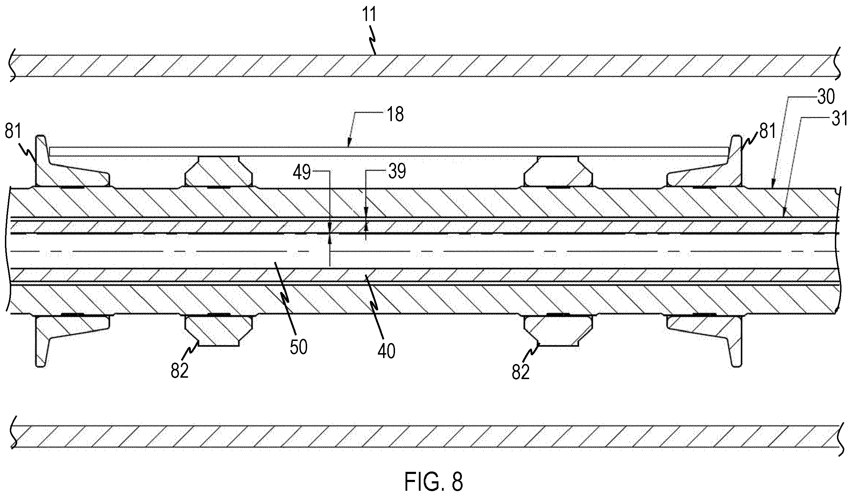

Figur 8 zeigt einen entlang der Längsrichtung der Welle 30 zentralen Bereich. Wie bereits unter Bezugnahme auf Figur 4 erläutert, ist die Innenfläche 31 der Welle 30 im zentralen Bereich von der Außenfläche 41 des Aufnahmedorns 40 um einen Spalt 39 beabstandet, der größer ist als ein Spalt zwischen der Heizpatrone 50 oder einer anderen elektrischen Heizeinrichtung 50 und der Innenfläche des Aufnahmedorns 40.

Die Welle 30 kann als Antriebswalze ausgestaltet sein. Die Welle 30 kann in einer Durchlaufanlage oder einer Batchanlage eingesetzt sein. An der Welle 30 können Führungselemente 81 zum seitlichen Führen des Substrats 18 oder des Substratträgers 18 angeordnet sein. An der Welle 30 können Abstützelemente 82 zum Abstützen einer Unterseite des Substrats 18 oder des Substratträgers 18 angeordnet sein. Die Führungselemente 81 und/oder Abstützelemente 82 können umlaufend um die Welle 30 angeordnet sein.

Figur 9 zeigt eine Teilansicht einer Behandlungsanlage nach einem bevorzugten Ausführungsbeispiel. Die drehbar gelagerte Welle 30 ist über ein Lager 14 drehbar an der Kammer 11 gelagert. Ein weiteres Lager 60 kann zwischen dem Aufnahmedorn 40 und der Welle 30 angeordnet sein. Aktive Heizelemente sind in der Heizpatrone 50 oder der anderen Heizeinrichtung 50 so angeordnet, dass sie sich nicht über ein Ende 53 eines Bereichs 51 hinaus erstrecken, der beabstandet von dem Lager 60 endet.

Dichtungen 17 können vorgesehen sein, um sicherzustellen, dass der Behandlungsraum 15 in der Kammer 11 auf einen statischen Druck kleiner als 1 Pa, insbesondere kleiner als 0,1 Pa, kleiner als $10^{-2}$ Pa, kleiner als $10^{-3}$ Pa oder kleiner als $10^{-4}$ Pa evakuierbar ist.

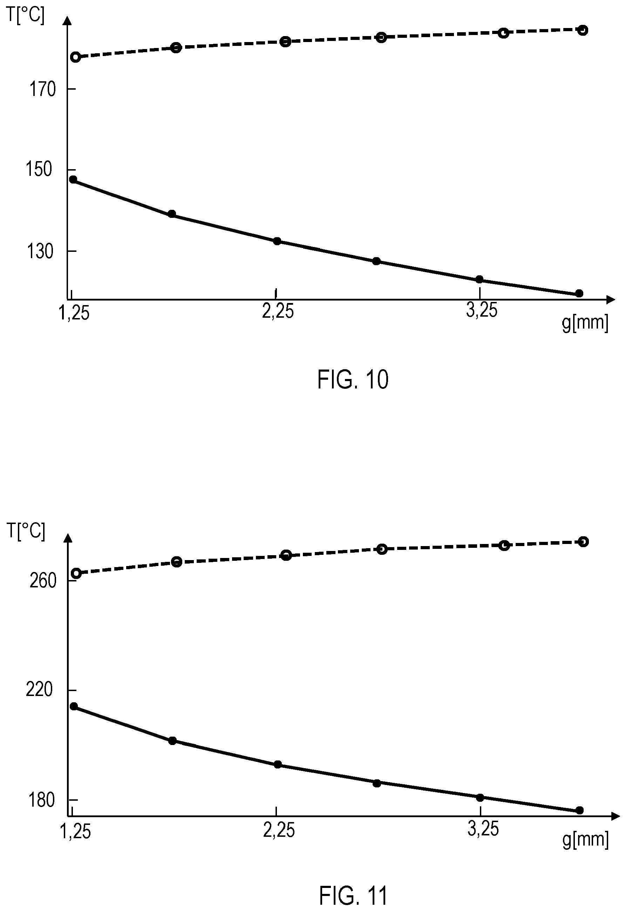

Figur 10, Figur 11 und Figur 12 zeigen jeweils eine Temperatur der Außenfläche des Aufnahmedorns 40 (offene Kreise und gestrichelte Linien) sowie eine Temperatur der Außenfläche der Welle 30 (gefüllte Kreise und durchgezogene Linien) als Funktion eines Abstands g (der dem in Fig. 4 und Fig. 8 dargestellten Abstand 39 entspricht) zwischen der Außenfläche 41 des Aufnahmedorns 40 und der Innenfläche 31 der Welle 30. Für die in Figur 10, Figur 11 und Figur 12 dargestellten Daten weist die Welle 30 einen Außenradius von 23 mm und einen Innenradius von 12,5 mm auf. Der Aufnahmedorn 40 weist einen Innenradius von 6,25 mm auf. Die Wandstärke des Aufnahmedorns 40 variiert zwischen 5,5 mm und 3 mm, so dass der Abstand g zwischen der Außenfläche 41 des Aufnahmedorns 40 und der Innenfläche 31 der Welle 30 von 0,75 mm bis 3,25 mm variiert.

In Figur 10 beträgt die Temperatur der Heizpatrone 200°C, und der Spalt zwischen der Außenfläche 41 des Aufnahmedorns 40 und der Innenfläche 31 der Welle 30 ist mit Luft gefüllt.

In Figur 11 beträgt die Temperatur der Heizpatrone 300°C, und der Spalt zwischen der Außenfläche 41 des Aufnahmedorns 40 und der Innenfläche 31 der Welle 30 ist mit Luft gefüllt.

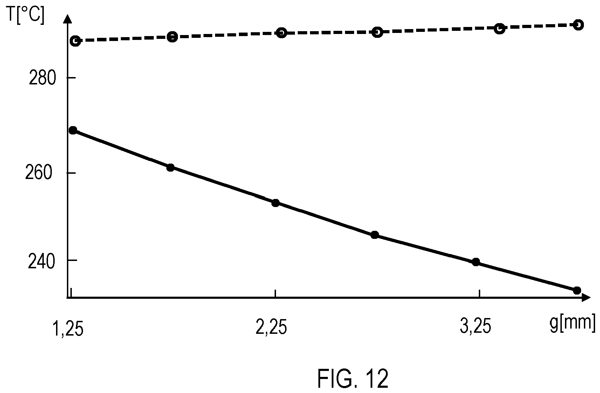

In Figur 12 beträgt die Temperatur der Heizpatrone 300°C, und der Spalt zwischen der Außenfläche 41 des Aufnahmedorns 40 und der Innenfläche 31 der Welle 30 ist mit Helium gefüllt.

Wie Figur 10, Figur 11 und Figur 12 verdeutlichen, kann bei Verwendung eines kleineren Spalts zwischen der Außenfläche 41 des Aufnahmedorns 40 und der Innenfläche 31 der Welle 30 (d.h. eines größeren Außendurchmessers d des Aufnahmedorns 40) die Wärmeübertragung an die Welle 30 verbessert und die Welle 30 auf eine höhere Temperatur geheizt werden.

Wie ein Vergleich zwischen Figur 11 und Figur 12 verdeutlicht, kann durch Verwendung von Helium als Gas im Spalt zwischen der Außenfläche 41 des Aufnahmedorns 40 und der Innenfläche 31 der Welle 30 die Wärmeübertragung an die Welle 30 verbessert und die Welle 30 auf eine höhere Temperatur geheizt werden als bei Verwendung von Luft im Innenvolumen der Welle 30.

Mehrere Antriebseinheiten mit der unter Bezugnahme auf Figur 2 bis Figur 12 detailliert beschriebenen Ausgestaltung können an einer einzigen Behandlungsanlage vorgesehen sein.

Die Behandlungsanlage und/oder Antriebseinheit können für verschiedene Zwecke eingesetzt werden. Beispielsweise kann die Behandlungsanlage als Dampfabscheidungsanlage ausgestaltet sein. Die Behandlungsanlage kann zur Abscheidung von Chalkogenen, beispielsweise von Selen, ausgestaltet sein. Dazu kann die Behandlungsanlage wenigstens eine Dampfquelle für Reaktionsdampf aufweisen. Alternativ oder zusätzlich kann die Behandlungsanlage zur Gasphasenabscheidung ausgestaltet sein und wenigstens eine Quelle für Reaktionsgas aufweisen. Alternativ oder zusätzlich kann die Behandlungsanlage oder die Antriebseinheit für eine thermische Behandlung von Substraten/auf den Substraten aufgebrachten Schichten eingesetzt werden.

Eine Steuerung oder Regelung der Heizpatrone 50 oder einer anderen elektrischen Heizeinrichtung 50 kann über ein Thermoelement oder mehrere Thermoelemente erfolgen.

Der Aufnahmedorn 40 kann je nach gewünschter Anwendung auf verschiedene Weise ausgestaltet sein. Vorteilhaft ist der Aufnahmedorn 40 so ausgestaltet, dass ein Quotient seiner Wandstärke zu seinem Außendurchmesser in einer Mittelebene der Kammer beispielsweise wenigstens 0,1, wenigstens 0,15 oder wenigstens 0,2 betragen kann. Der Aufnahmedorn 40 enthält vorteilhaft Normalstahl oder besteht aus Normalstahl.

Bei einer beispielhaften Ausführungsform kann der stehende, sich nicht mit der Welle 30 mitdrehende Aufnahmedorn 40 zur Aufnahme einer elektrischen Standard-Heizpatrone ausgestaltet sein. Die Heizpatrone kann Wärmeenergie über einen geringen Spalt, der beispielsweise maximal 0,5 mm oder maximal 0,25 mm betragen kann, an den Aufnahmedorn 40 abgeben. Dadurch wird sichergestellt, dass die Heizpatrone ihre Wärmeenergie effizient übertragen kann und nicht überhitzt. Negative Einflüsse auf die Lebensdauer der Heizpatrone 50 können unterbunden werden.

Durch die relativ große Wandstärke des Aufnahmedorns 40 kann dieser Wärmeenergie effizient aufnehmen und dann an die drehbar gelagerte Welle abgeben. Die Wandstärke des Aufnahmedorns kann in einer Mittelebene der Kammer 11 beispielsweise mindestens 2 mm, mindestens 3 mm, mindestens 4 mm oder ungefähr 4,5 mm betragen. Eine derartige Ausgestaltung ist besonders für Wellenlängen von mehr als 600 mm geeignet, ohne hierauf beschränkt zu sein.

Die Antriebseinheit und Behandlungsanlage nach verschiedenen Ausführungsbeispielen erlauben eine Temperierung einer sich im Betrieb drehenden Welle 30, insbesondere ein Heizen der sich im Betrieb drehenden Welle 30. Die bei Öl-temperierten Wellen häufig auftretenden Probleme mit Leckagen an Drehdurchführungen können vermieden werden. Durch die Verwendung eines Aufnahmedorns 40, in den eine Heizpatrone 50 oder eine andere elektrische Heizeinrichtung 50 als Austauschteil einschiebbar ist, ist es nicht erforderlich, die Heizpatrone 50 über einen Schleifringkontakt zu kontaktieren. Durch die Ausgestaltung des Aufnahmedorns 40 als passives Bauteil kann eine einfache Konstruktion implementiert werden. Eine effiziente Wärmeübertragung auf die Welle 30 kann durch ein Gas im Spalt zwischen dem Aufnahmedorn 40 und der Welle 30 erreicht werden.

Ausführungsbeispiele der Erfindung können vorteilhaft für Anlagen zur Dampfphasenabscheidung, Gasphasenabscheidung und/oder thermischen Behandlung von Substraten eingesetzt werden, ohne hierauf beschränkt zu sein. Ausführungsbeispiele der Erfindung können vorteilhaft bei Durchlaufanlagen oder Batchanlagen eingesetzt werden.

**Patentansprüche**

1.    Behandlungsanlage, aufweisend:

eine Kammer (11) zur Behandlung eines Substrats (18) oder mehrerer Substrate (18),
eine drehbar gelagerte temperierte Welle (30), wobei die Welle (30) einen zylinderförmigen, gasdichten Hohlraum definiert, und
eine Heizanordnung (40, 50) zum elektrischen Heizen wenigstens eines in der Kammer (11) angeordneten Teils der Welle (30),
wobei die Heizanordnung (40, 50) einen Aufnahmedorn (40) zum Aufnehmen wenigstens eines elektrischen Heizelements (50), insbesondere einer Heizpatrone, aufweist, der drehfest angeordnet ist und sich in den Hohlraum der Welle (30) erstreckt,
wobei eine Außenfläche (41) des Aufnahmedorns (40) durch einen Spalt (39) von einer Innenfläche (31) der Welle (30) beabstandet ist.

2.    Behandlungsanlage nach Anspruch 1, wobei die Welle (30) teilbar ausgeführt ist, wobei Teilungsstellen der Welle (30) mit einer Dichtung (37, 38) versehen sind, um ein Volumen, das zwischen dem Aufnahmedorn (40) und der Innenfläche (31) der Welle (30) definiert ist, gegenüber einem durch die Kammer (11) definierten Behandlungsraum (15) abzudichten.

3.    Behandlungsanlage nach Anspruch 1 oder Anspruch 2, ferner aufweisend eine Evakuierungseinrichtung zum Evakuieren des Behandlungsraums (15), wobei der Behandlungsraum (15) vorzugsweise auf einen statischen Druck kleiner als 1 Pa, insbesondere kleiner als 0,1 Pa, insbesondere kleiner als $10^{-2}$ Pa, insbesondere kleiner als $10^{-3}$ Pa, und insbesondere kleiner als $10^{-4}$ Pa evakuierbar ist.

4.    Behandlungsanlage nach einem der vorhergehenden Ansprüche, wobei die Behandlungsanlage (10) konfiguriert ist, in einem Volumen, das zwischen dem Aufnahmedorn (40) und der Welle (30) definierten ist, einen Überdruck gegenüber einem durch die Kammer (11) definierten Behandlungsraum (15) aufrecht zu erhalten, insbesondere den Druck in dem zwischen dem Aufnahmedorn (40) und der Welle (30) definierten Volumen bei Evakuierung des Behandlungsraums (15) bei Atmosphärendruck zu halten, wobei optional in dem zwischen dem Aufnahmedorn (40) und der Welle (30) definierten Volumen ein gasförmiges Medium, insbesondere Luft, Helium oder Wasserstoff, vorhanden ist.

5.    Behandlungsanlage nach einem der vorhergehenden Ansprüche,
wobei der Spalt (39) zwischen der Außenfläche (41) des Aufnahmedorns (40) und der Innenfläche (31) der Welle (30) kleiner als 3 mm, kleiner als 2,2 mm oder kleiner als 1,9 mm ist.

6.    Behandlungsanlage nach einem der vorhergehenden Ansprüche,
wobei eine Wärmeleitfähigkeit zwischen der Außenfläche (41) des Aufnahmedorns (40) mit einem Durchmesser von wenigstens 15mm, wenigstens 20mm oder wenigstens 22mm und der Innenfläche (31) der Welle (30) pro axialer Längeneinheit der Außenfläche (41) des Aufnahmedorns (40) wenigstens 0,4 W/(K·m) oder wenigstens 0.5 W/(K·m), beträgt.

7.    Behandlungsanlage nach einem der vorhergehenden Ansprüche,
wobei die Welle (30) über wenigstens ein Lager (14) mit der Kammer (11) drehbar verbunden ist, ferner vorzugsweise aufweisend wenigstens ein Lager (60) zwischen dem Aufnahmedorn (40) und der Innenfläche (31) der Welle (30).

8.    Behandlungsanlage nach einem der vorhergehenden Ansprüche, wobei der Aufnahmedorn (40) einen weiteren zylinderförmigen Hohlraum in seinem Inneren definiert, ferner vorzugsweise aufweisend eine Heizpatrone (50), die im weiteren zylinderförmigen Hohlraum des Aufnahmedorns (40) angeordnet ist oder angeordnet werden kann.

9. Behandlungsanlage nach Anspruch 18 oder Anspruch 19, wobei der weitere zylinderförmige Hohlraum ein Material zwischen der Heizpatrone (50) und dem Aufnahmedorn (40) aufweist, wobei das Material eine Wärmeleitfähigkeit von wenigstens 0,05 W/(K·m), insbesondere von wenigstens 0,1 W/(K·m), bevorzugt wenigstens 4 W/(K·m), stärker bevorzugt von wenigstens 6 W/(K·m) aufweist.

10. Behandlungsanlage nach einem der vorhergehenden Ansprüche, wobei das elektrische Heizelement (50) ein integraler Bestandteil des Aufnahmedorns (40), vorzugweise mit diesem vergossen, ist.

11. Behandlungsanlage nach einem der vorhergehenden Ansprüche, wobei der Aufnahmedorn (40) zum Austausch des elektrischen Heizelements (50) aus dem Hohlraum der Welle (30) entnommen werden kann.

12. Behandlungsanlage nach Anspruch 11, wobei der Aufnahmedorn an seinem distalen Ende im Hohlraum der Welle (30) gelagert ist und an seinem distalen Ende eine Verjüngung aufweist, um in das Lager (60) eingeführt zu werden.

13. Antriebseinheit (20a-c) für eine Behandlungsanlage (10), aufweisend:

    eine drehbare Welle (30), wobei die Welle (30) einen zylinderförmigen Hohlraum definiert,
    eine Heizanordnung (40, 50) zum elektrischen Heizen wenigstens eines Teils der Welle (30), wobei die Heizanordnung (40, 50) einen Aufnahmedorn (40) zum Aufnehmen wenigstens eines elektrischen Heizelements (50), insbesondere einer Heizpatrone, aufweist, der drehfest montierbar ist und der sich in den Hohlraum der Welle (30) erstreckt, wobei eine Außenfläche (41) des Aufnahmedorns (40) durch einen Spalt (39) von einer Innenfläche (31) der Welle (30) beabstandet ist.

14. Antriebseinheit nach Anspruch 13, ferner aufweisend eine Heizpatrone (50), die in einem weiteren zylinderförmigen Hohlraum des Aufnahmedorns (40) angeordnet ist oder angeordnet werden kann.

15. Antriebseinheit nach einem der Ansprüche 13 bis 14, wobei das elektrische Heizelement (50) ein integraler Bestandteil des Aufnahmedorns (40), vorzugweise mit diesem vergossen, ist, wobei vorzugsweise der Aufnahmedorn (40) zum Austausch des elektrischen Heizelements (50) aus dem Hohlraum der Welle (30) entnommen werden kann.

FIG. 1

FIG. 2

FIG. 3

FIG. 4

30

60

40

FIG. 5

FIG. 6

FIG. 7

FIG. 8

FIG. 9

FIG. 10

FIG. 11

FIG. 12

Europäisches
Patentamt

European
Patent Office

Office européen
des brevets

## EUROPEAN SEARCH REPORT

Application Number

EP 20 21 2840

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 100 990 237 B1 (NPS CORP [KR]) 29 October 2010 (2010-10-29) | 1,4-6,8, 9,11,13, 14 | INV. H01L21/67 H01L21/677 |
| Y | * paragraphs 29-33,35 - pages 3,4 * | 2,3,7 | |
| Y,D | DE 10 2011 082334 A1 (ARDENNE ANLAGENTECH GMBH [DE]) 14 March 2013 (2013-03-14) * paragraph [0021]; figure 1 * | 2,3 | ADD. C23C14/56 |
| Y,D | DE 10 2009 016677 A1 (BHS CORR MASCH & ANLAGENBAU [DE]) 21 October 2010 (2010-10-21) * figure 6 * | 7 | |
| X | EP 2 013 375 A2 (FIRST SOLAR INC [US]) 14 January 2009 (2009-01-14) * paragraphs [0011], [0029], [0061]; figures 5,6 * | 1,10,12, 13,15 | |

TECHNICAL FIELDS
SEARCHED (IPC)

H01L
C23C

The present search report has been drawn up for all claims

| Place of search | Date of completion of the search | Examiner |
|---|---|---|
| The Hague | 23 April 2021 | Müller-Kirsch, Lutz |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 21 2840

23-04-2021

| Patent document cited in search report | Publication date | Patent family member(s) | Publication date |
|---|---|---|---|
| KR 100990237 B1 | 29-10-2010 | NONE | |
| DE 102011082334 A1 | 14-03-2013 | NONE | |
| DE 102009016677 A1 | 21-10-2010 | DE 102009016677 A1<br>EP 2239531 A2<br>ES 2594777 T3<br>US 2010255971 A1 | 21-10-2010<br>13-10-2010<br>22-12-2016<br>07-10-2010 |
| EP 2013375 A2 | 14-01-2009 | AT 548480 T<br>EP 2013375 A2<br>MY 148149 A<br>US 2007237894 A1<br>US 2015203963 A1<br>WO 2007127007 A2 | 15-03-2012<br>14-01-2009<br>15-03-2013<br>11-10-2007<br>23-07-2015<br>08-11-2007 |

EPO FORM P0459

For more details about this annex : see Official Journal of the European Patent Office, No. 12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009016677 A1
- EP 0918945 B1
- DE 693659 A
- DE 3033689 A1
- DE 102011082334 A1